(19) Europäisches Patentamt
European Patent Office
Office européen des brevets

(11) **EP 4 685 657 A1**

(12) **EUROPEAN PATENT APPLICATION**
published in accordance with Art. 153(4) EPC

(43) Date of publication:
28.01.2026 Bulletin 2026/05

(21) Application number: 24796144.4

(22) Date of filing: 25.04.2024

(51) International Patent Classification (IPC):
*G06F 16/174* (2019.01)    *G06F 16/176* (2019.01)

(52) Cooperative Patent Classification (CPC):
G06F 16/174; G06F 16/176; H03M 7/30;
H04L 69/04

(86) International application number:
PCT/CN2024/089694

(87) International publication number:
WO 2024/222768 (31.10.2024 Gazette 2024/44)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.04.2023 CN 202310473699
30.06.2023 CN 202310803573

(71) Applicant: Huawei Technologies Co., Ltd.
Shenzhen, Guangdong 518129 (CN)

(72) Inventors:
• DONG, Ruliang
  Shenzhen, Guangdong 518129 (CN)
• LUO, Sizhe
  Shenzhen, Guangdong 518129 (CN)
• ZHU, Hongde
  Shenzhen, Guangdong 518129 (CN)
• SUN, Yong
  Shenzhen, Guangdong 518129 (CN)

(74) Representative: Maiwald GmbH
Elisenhof
Elisenstraße 3
80335 München (DE)

(54) **DATA COMPRESSION METHOD AND RELATED SYSTEM**

(57) This application provides a data compression method, including: obtaining a to-be-persisted data file, where the to-be-persisted data file includes a plurality of sub-files; and during persistence of a first sub-file in the plurality of sub-files, generating, based on the first sub-file, a dictionary corresponding to the first sub-file, and compressing the first sub-file by using the dictionary, to obtain a first compressed file; generating a first persistent file based on the first compressed file and the dictionary; and writing the first persistent file into a persistent storage medium. A single persistent file independently maintains a dictionary corresponding to a sub-file. The dictionary and the sub-file may implement same life cycle management. That is, a life cycle of data in the sub-file and a life cycle of the dictionary are affinity-bound. This solves a long-tail problem that a public dictionary cannot be released because a local data file references a global public dictionary. In this way, the following problem is avoided: Metadata expansion is caused because the public dictionary occupies a memory for a long time and cannot be released; consequently, performance deterioration of a storage system is further caused.

FIG. 7

**Description**

This application claims priorities to Chinese Patent Application No. 202310473699.2, filed with the China National Intellectual Property Administration on April 26, 2023 and entitled "DATA COMPRESSION METHOD", and to Chinese Patent Application No. 202310803573.7, filed with the China National Intellectual Property Administration on June 30, 2023 and entitled "DATA COMPRESSION METHOD AND RELATED SYSTEM", both of which are incorporated herein by reference in their entireties.

**TECHNICAL FIELD**

This application relates to the field of storage technologies, and in particular, to a data compression method and apparatus, a storage system, a computer-readable storage medium, and a computer program product.

**BACKGROUND**

Wide application of cloud computing and rapid popularization of fifth generation (fifth generation, 5G) communication systems and big data are accelerating data production and flow, promoting continuous release of data value, and posing a greater challenge to data storage capacity. A larger data volume and a longer storage period indicate higher storage costs. This poses higher requirements for cost-effectiveness in data-centric infrastructure and a memory-centric system architecture. Massive data storage becomes a key factor that affects procurement and maintenance costs of data center infrastructure.

Data storage vendors launch corresponding data reduction features, to significantly increase an available capacity for users under a same physical capacity and therefore reduce a total cost of ownership (total cost of ownership, TCO). Currently, data compression algorithms such as LZ4, ZSTD, and Snappy are launched in the industry to implement data reduction features. The data compression algorithms can achieve data compression ratios of up to multi-fold. However, due to exponential growth in a data volume, the data compression algorithms are gradually unable to fully meet requirements for massive data production, storage, and application.

The data storage vendors attempt to use public dictionary (Public Dictionary, PD) compression to push beyond the limits of the compression algorithms such as LZ4 and Snappy. Public dictionary compression can further increase data reduction ratios by mining richer data features in a broader range. However, a public dictionary provides global information independent of a data file of a user, and different data files (for example, data files corresponding to different columns in a database table) can reference a same public dictionary. A life cycle difference between a local data file and a global public dictionary causes a long-tail problem that the public dictionary occupies a memory for a long time and cannot be released. Consequently, the memory occupied by the public dictionary increases sharply, which affects performance of a storage system.

**SUMMARY**

This application provides a data compression method. In the method, a single persistent file independently maintains a dictionary corresponding to a sub-file. The dictionary and the sub-file may implement same life cycle management. That is, a life cycle of data in the sub-file and a life cycle of the dictionary are affinity-bound. This solves a long-tail problem that a public dictionary cannot be released because local data files reference a global public dictionary, and ensures performance of a storage system. This application further provides an apparatus, a storage system, a computer-readable storage medium, and a computer program product corresponding to the foregoing method.

According to a first aspect, this application provides a data compression method. The method may be performed by a storage system. The storage system may be a centralized storage system, including a disk-controller integrated centralized storage system and a disk-controller separated centralized storage system. Alternatively, the storage system may be a distributed storage system, including but not limited to a computing-in-memory distributed storage system and a storage-compute decoupled distributed storage system.

Specifically, the storage system obtains a to-be-persisted data file, where the to-be-persisted data file includes a plurality of sub-files; and during persistence of a first sub-file in the plurality of sub-files, generates, based on the first sub-file, a dictionary corresponding to the first sub-file, and compresses the first sub-file by using the dictionary, to obtain a first compressed file; generates a first persistent file based on the first compressed file and the dictionary; and writes the first persistent file into a persistent storage medium.

In this method, the storage system persists, in a same persistent file, the dictionary and the compressed file obtained by compressing the sub-file by using the dictionary. The dictionary and the sub-file may implement same life cycle management. That is, a life cycle of data in the sub-file and a life cycle of the dictionary are affinity-bound. This solves a long-tail problem that a public dictionary cannot be released because a local data file references a global public dictionary.

In this way, the following problem is avoided: Metadata expansion (metadata overflow) is caused because the public dictionary occupies the memory for a long time and cannot be released; consequently, the public dictionary that needs to be used consequently cannot be hit in a memory, frequent swap-in and swap-out are required, and performance deterioration of the storage system is further caused.

In some possible implementations, the first persistent file includes a data area and a metadata area that are pre-allocated, the data area stores the first compressed file, and a specified location in the metadata area stores the dictionary corresponding to the first sub-file. The specified location is determined based on configuration information for pre-allocating the metadata area. The configuration information for pre-allocating the metadata area includes an offset of the metadata area in the first persistent file and an offset of the dictionary in the metadata area.

In this method, a separated space reservation strategy is used, to obtain the data area and the metadata area through segmentation in the persistent file, and complete space reservation in advance when the persistent file is generated. In this way, after the dictionary is generated, the dictionary is pre-filled in corresponding space reserved in the metadata area (that is, the dictionary is filled in the reserved metadata area). There is a natural mapping relationship between the data area and the metadata area, so that metadata non-intrusiveness and zero-overhead maintenance can be implemented, and functions such as persistence of mapping metadata and mapping update do not need to be additionally added. This reduces impact on an existing storage system architecture, and reduces development difficulty and system complexity.

In some possible implementations, the storage system may receive a read request, where the read request is used to read the first sub-file. Then, the storage system reads the dictionary corresponding to the first sub-file from the specified location in the metadata area of the first persistent file based on the configuration information for pre-allocating the metadata area, and reads the first compressed file from the data area of the first persistent file based on configuration information for pre-allocating the data area, where the configuration information for pre-allocating the data area includes an offset of the data area in the first persistent file. The storage system may decompress the first compressed file by using the dictionary corresponding to the first sub-file, to obtain the first sub-file.

For the read request from an upper layer, the storage system may perform precise prefetching with reference to fixed index information (such as an offset) of each persistent file for dictionary space, to improve a cache hit rate for subsequent read request hit, greatly reduce input/output (input/output, I/O) paths, and improve read performance.

In some possible implementations, as data is written and overwritten, invalid data (junk data) may be generated in the persistent file. The invalid data and the junk data are rewritten data, for example, rewritten data in a sub-file corresponding to a compressed file stored in the data area of the persistent file. Valid data is opposite to the invalid data, and the valid data is unrewritten data. The storage system may further reclaim the junk data to release space. Specifically, the storage system may detect whether a merging condition is met. When the merging condition is met, the storage system merges a plurality of persistent files that have been written into the persistent storage medium, to obtain a new persistent file, and deletes the plurality of persistent files.

In this way, the junk data of the persistent file can be reclaimed, a waste of storage space is avoided, and storage resource utilization is improved.

In some possible implementations, the storage system may decompress the plurality of persistent files that have been written into the persistent storage medium, respectively obtain valid data from sub-files obtained through decompression, and merge the valid data to obtain a merged sub-file. The valid data is unrewritten data. Then, the storage system may generate, based on the merged sub-file, a dictionary corresponding to the merged sub-file, and compress the merged sub-file by using the dictionary corresponding to the merged sub-file, to obtain a compressed merged file; and generate the new persistent file based on the compressed merged file and the dictionary corresponding to the merged sub-file.

Affinity binding between a life cycle of data (for example, the sub-file in the data file) and a life cycle of the dictionary can be implemented, zero misalignment between the data and the dictionary is implemented, and no metadata is amplified, to avoid a performance problem caused by metadata overflow. In addition, a new dictionary that conforms to a feature of the merged sub-file is generated, so that a better compression ratio can be obtained.

In a possible implementation, the merging condition includes at least one of the following:

an interval between current time and last merging time reaches a merging cycle;
current load is less than a preset value;
a valid data proportion of at least one of the plurality of persistent files that have been written into the persistent storage medium is less than a preset proportion, where the valid data proportion is a proportion of unrewritten data in a sub-file corresponding to the persistent file; or
a merging request reported when a user triggers a merging operation is detected.

The method supports a plurality of merging manners, for example, supports periodic merging, idle-period merging, merging based on the valid data proportion, or manually-triggered merging, which can meet requirements of different services and have high availability.

In some possible implementations, the storage system may determine, based on attribute information of persistent files that have been written into the persistent storage medium, the plurality of to-be-merged persistent files, and merge the plurality of persistent files to obtain the new persistent file.

In the method, the persistent files that have been written into the persistent storage medium are screened based on the attribute information of the persistent files, to determine the plurality of to-be-merged persistent files, instead of merging any persistent file. In this way, merging benefits are greater than merging overheads, and a service requirement is met.

In some possible implementations, attribute information of the persistent file includes write time or a valid data proportion, and the valid data proportion is a proportion of unrewritten data in a sub-file corresponding to the persistent file. Correspondingly, the storage system may sort, based on write time of the persistent files that have been written into the persistent storage medium, the persistent files that have been written into the persistent storage medium, and determine, based on a sorting result, the plurality of to-be-merged persistent files. Alternatively, the storage system may determine, based on valid data proportions of the persistent files that have been written into the persistent storage medium, the plurality of to-be-merged persistent files, where the plurality of to-be-merged persistent files include persistent files whose valid data proportions are less than the preset proportion.

In the method, the storage system may determine the to-be-merged persistent files according to a first-in first-out principle, or determine the to-be-merged persistent files according to a principle of preferentially merging persistent files with high proportions of junk data, and then merge the persistent files, to obtain high merging benefits to a greatest extent.

In some possible implementations, the storage system may further update physical addresses in an address mapping relationship of the plurality of persistent files to a physical address of the new persistent file. In this way, when receiving a read request for reading valid data in a sub-file corresponding to a deleted persistent file, the storage system may index the new persistent file based on an updated address mapping relationship, to implement precise read and ensure read performance.

In some possible implementations, when receiving a write request, the storage system may further first write data in the write request into a log, obtain a to-be-persisted data file from the log for persistence, and generate a dictionary in a log flushing process. If a fault occurs in this phase, data may be replayed because the log still exists, so that the dictionary can be regenerated. In this way, data write protection can be implemented, to ensure high reliability and high availability of the data.

According to a second aspect, this application provides a data compression apparatus. The apparatus includes:

an obtaining module, configured to obtain a to-be-persisted data file, where the to-be-persisted data file includes a plurality of sub-files; and
a persistence module, configured to: during persistence of a first sub-file in the plurality of sub-files,
generate, based on the first sub-file, a dictionary corresponding to the first sub-file, and compress the first sub-file by using the dictionary, to obtain a first compressed file;
generate a first persistent file based on the first compressed file and the dictionary; and
write the first persistent file into a persistent storage medium.

In some possible implementations, the first persistent file includes a data area and a metadata area that are pre-allocated, the data area stores the first compressed file, a specified location in the metadata area stores the dictionary corresponding to the first sub-file, the specified location is determined based on configuration information for pre-allocating the metadata area, and the configuration information for pre-allocating the metadata area includes an offset of the metadata area in the first persistent file and an offset of the dictionary in the metadata area.

In some possible implementations, the obtaining module is further configured to:
receive a read request, where the read request is used to read the first sub-file.

The apparatus further includes:

a data reading module, configured to: read the dictionary corresponding to the first sub-file from the specified location in the metadata area of the first persistent file based on the configuration information for pre-allocating the metadata area, and read the first compressed file from the data area of the first persistent file based on configuration information for pre-allocating the data area, where the configuration information for pre-allocating the data area includes an offset of the data area in the first persistent file; and
decompress the first compressed file by using the dictionary corresponding to the first sub-file, to obtain the first sub-file.

In some possible implementations, the apparatus further includes:

a detection module, configured to detect whether a merging condition is met; and

a merging module, configured to: when the merging condition is met, merge a plurality of persistent files that have been written into the persistent storage medium, to obtain a new persistent file; and delete the plurality of persistent files.

In some possible implementations, the merging module is specifically configured to:

decompress the plurality of persistent files that have been written into the persistent storage medium, respectively obtain valid data from sub-files obtained through decompression, and merge the valid data to obtain a merged sub-file, where the valid data is unrewritten data;

generate, based on the merged sub-file, a dictionary corresponding to the merged sub-file, and compress the merged sub-file by using the dictionary corresponding to the merged sub-file, to obtain a compressed merged file; and generate the new persistent file based on the compressed merged file and the dictionary corresponding to the merged sub-file.

In a possible implementation, the merging condition includes at least one of the following:

an interval between current time and last merging time reaches a merging cycle;

current load is less than a preset value;

a valid data proportion of at least one of the plurality of persistent files that have been written into the persistent storage medium is less than a preset proportion, where the valid data proportion is a proportion of unrewritten data in a sub-file corresponding to the persistent file; or

a merging request reported when a user triggers a merging operation is detected.

In some possible implementations, the merging module is specifically configured to:

determine, based on attribute information of persistent files that have been written into the persistent storage medium, the plurality of to-be-merged persistent files; and

merge the plurality of persistent files to obtain the new persistent file.

In some possible implementations, attribute information of the persistent file includes write time or a valid data proportion, and the valid data proportion is a proportion of unrewritten data in a sub-file corresponding to the persistent file.
The merging module is specifically configured to:

sort, based on write time of the persistent files that have been written into the persistent storage medium, the persistent files that have been written into the persistent storage medium, and determine, based on a sorting result, the plurality of to-be-merged persistent files; or

determine, based on valid data proportions of the persistent files that have been written into the persistent storage medium, the plurality of to-be-merged persistent files, where the plurality of to-be-merged persistent files include persistent files whose valid data proportions are less than the preset proportion.

In some possible implementations, the apparatus further includes:
an address mapping update module, configured to update physical addresses in an address mapping relationship of the plurality of persistent files to a physical address of the new persistent file.
According to a third aspect, this application provides a storage system. The storage system includes a controller and a hard disk. The controller and the hard disk communicate with each other. The controller is configured to execute computer-readable instructions, so that the storage system performs the data compression method based on the first aspect or any one of the implementations of the first aspect.
According to a fourth aspect, this application provides a computer-readable storage medium. The computer-readable storage medium stores instructions, and the instructions instruct a storage system to perform the data compression method based on the first aspect or any one of the implementations of the first aspect.
According to a fifth aspect, this application provides a computer program product including instructions. When the computer program product is run on a storage system, the storage system is enabled to perform the data compression method based on the first aspect or any one of the implementations of the first aspect.
In this application, on the basis of the implementations according to the foregoing aspects, the implementations may be further merged to provide more implementations.

**BRIEF DESCRIPTION OF DRAWINGS**

To describe the technical methods in embodiments of this application more clearly, the following briefly describes the accompanying drawings for describing embodiments.

FIG. 1A is a diagram of an architecture of a disk-controller separated centralized storage system according to an embodiment of this application;
FIG. 1B is a diagram of an architecture of a disk-controller integrated centralized storage system according to an embodiment of this application;
FIG. 1C is a diagram of an architecture of a computing-in-memory distributed storage system according to an embodiment of this application;
FIG. 1D is a diagram of an architecture of a storage-compute decoupled distributed storage system according to an embodiment of this application;
FIG. 2 is a flowchart of a data compression method according to an embodiment of this application;
FIG. 3 is a schematic flowchart of dictionary generation according to an embodiment of this application;
FIG. 4 is a schematic flowchart of persistent file reclamation according to an embodiment of this application;
FIG. 5 is a schematic flowchart of a data compression method in a database according to an embodiment of this application;
FIG. 6 is a schematic flowchart of a data compression method in a distributed storage system according to an embodiment of this application;
FIG. 7 is a schematic flowchart of data read/write according to an embodiment of this application; and
FIG. 8 is a diagram of a structure of a computer cluster according to an embodiment of this application.

## DESCRIPTION OF EMBODIMENTS

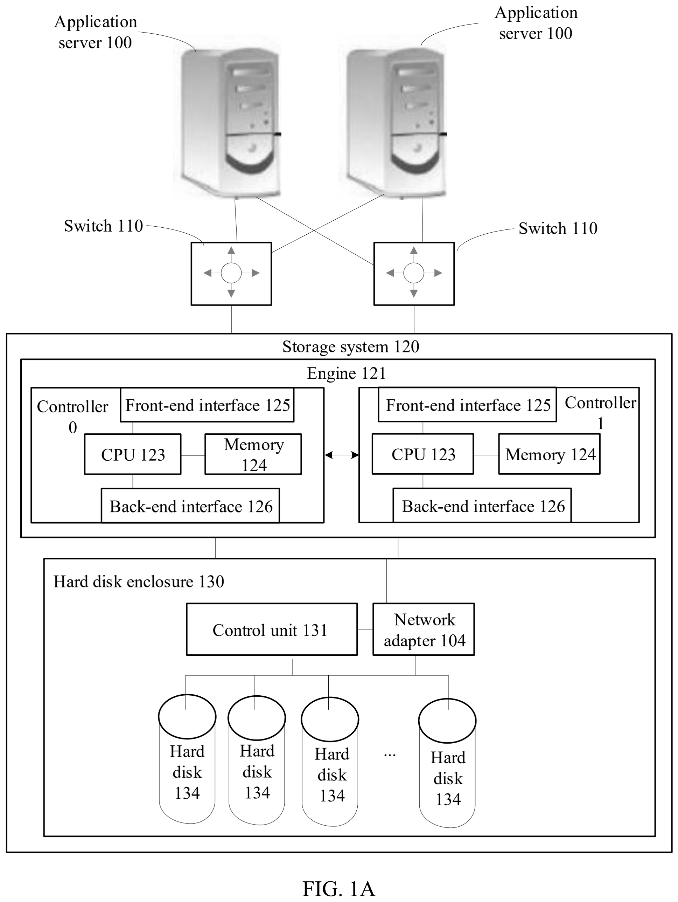

The terms "first" and "second" in embodiments of this application are merely intended for description, and shall not be understood as an indication or implication of relative importance or an implicit indication of a quantity of indicated technical features. Therefore, a feature limited by "first" or "second" may explicitly or implicitly include one or more features.
First, some technical terms in embodiments of this application are described.
Data compression (data compression, DC): Data compression is a process of representing information with data bits (or another information-related unit) fewer than those in an uncoded case based on a specific coding mechanism. Data compression may be applied to text, audio, video, or image compression, to reduce storage space occupation and storage costs.
A data compression method provided in this application may be applied to storage systems. The foregoing storage systems may be classified into the following types based on logical functions: primary storage (primary storage) and backup storage (backup storage). As a storage pool or a hard disk of an upper-layer application, the primary storage can be accessed by the upper-layer application, such as an application deployed in a virtual machine (virtual machine, VM) manner. The backup storage is used as a repository to store images, backup magnetic disks, or snapshots. Usually, the VM cannot directly access the backup storage. The primary storage and the backup storage may be physically separated storage systems, or a same storage system may serve as both the primary storage and the backup storage. The storage systems may alternatively be classified into file storage, database storage (including a row-based database or a column-based database), and big data storage based on application scenarios.
The foregoing storage systems (including the primary storage and the backup storage) may use a local storage mode or a cloud storage mode. Local storage is a mode in which data is stored in a self-owned physical storage device. Cloud storage is a mode in which data is stored in a cloud environment to support data access through a network. The cloud environment is a cluster constructed by a cloud service provider (also referred to as a cloud vendor) to provide computing resources, storage resources, and network resources.
The storage system may be of a centralized storage architecture or a distributed storage architecture. In other words, the storage system may be a centralized storage system or a distributed storage system. The following separately provides examples for description.
The centralized storage system means that one or more main devices form a central node. Data is centrally stored on the central node, and all data processing services of the entire system are centrally deployed on the central node. In other words, in the centralized storage system, a terminal or a client is only responsible for data input and output, and data storage and control processing are completely completed by the central node. A most important feature of the centralized system is that a deployment structure is simple. There is no need to consider how to deploy a plurality of nodes for a service, and therefore there is no need to consider distributed collaboration between the plurality of nodes.
For ease of understanding, FIG. 1A is a diagram of an architecture of a centralized storage system according to an embodiment of this application. In an application scenario shown in FIG. 1A, a user accesses data through applications. A computer running these applications is called an "application server". The application server 100 may be a physical machine or a virtual machine VM. Physical machines (physical application servers) include but are not limited to a desktop computer, a server, a laptop, and a mobile device. The application server accesses the storage system through a fibre channel switch 110 to access data. However, the fibre channel switch 110 is only an optional device, and the application server 100 may alternatively directly communicate with the storage system 120 through a network. Alternatively, the fibre channel switch 110 may be replaced with an Ethernet switch, an InfiniBand (InfiniBand, IB) switch, an RDMA over converged Ethernet (RDMA over Converged Ethernet, RoCE) switch, or the like.

The storage system 120 shown in FIG. 1A is a centralized storage system. The centralized storage system features a unified portal, and all data from an external device passes through this portal. The portal is an engine 121 of the centralized storage system. The engine 121 is a core component of the centralized storage system, and a large quantity of advanced functions of the storage system are implemented in the engine 121.

As shown in FIG. 1A, the engine 121 includes one or more controllers. In FIG. 1A, an example in which the engine includes two controllers is used for description. There is a mirror channel between a controller 0 and a controller 1. Therefore, after writing a piece of data into a memory 124 of the controller 0, the controller 0 may send a copy of the data to the controller 1 through the mirror channel, and the controller 1 stores the copy in a local memory 124 of the controller 1. Therefore, the controller 0 and the controller 1 back up each other. When a fault occurs on the controller 0, the controller 1 may take over a service of the controller 0, and when a fault occurs on the controller 1, the controller 0 may take over a service of the controller 1, to avoid unavailability of the entire storage system 120 caused by a hardware fault. When four controllers are deployed in the engine 121, a mirror channel exists between any two controllers, and therefore any two controllers back up each other.

The engine 121 further includes a front-end interface 125 and a back-end interface 126, where the front-end interface 125 is configured to communicate with the application server 100, so as to provide a storage service for the application server 100. The back-end interface 126 is configured to communicate with a hard disk 134, to expand a capacity of the storage system. The engine 121 may be connected to more hard disks 134 through the back-end interface 126, to form a large storage resource pool.

In terms of hardware, as shown in FIG. 1A, the controller 0 includes at least a processor 123 and the memory 124. The processor 123 is a central processing unit (central processing unit, CPU), and is configured to process a data access request from outside the storage system (a server or another storage system), and is further configured to process a request generated inside the storage system. For example, when receiving, through the front-end port 125, a data write request sent by the application server 100, the processor 123 temporarily stores data in the data write request in the memory 124. When a total amount of data in the memory 124 reaches a specific threshold, the processor 123 sends, through the back-end port, data stored in the memory 124 to the hard disk 134 for persistent storage.

The memory 124 is a memory that directly exchanges data with the processor. The memory 124 can read and write data at a high speed at any time, and serves as a temporary data memory of an operating system or another running program. The memory includes at least two types of storages. For example, the memory may be a random access memory, or may be a read-only memory (Read-Only Memory, ROM). For example, the random access memory is a dynamic random access memory (Dynamic Random Access Memory, DRAM) or a storage-class memory (Storage-Class Memory, SCM), and the read-only memory may be a programmable read-only memory (Programmable Read-Only Memory, PROM), an erasable programmable read-only memory (Erasable Programmable Read-Only Memory, EPROM), or the like.

The memory 124 stores a software program, and the processor 123 may run the software program in the memory 124 to manage the hard disk. For example, the hard disk is abstracted into a storage resource pool and then divided into LUNs to be provided for a server for use or the like. The LUN herein is actually a hard disk seen on the server. Certainly, some centralized storage systems are also file servers, and may provide a file sharing service for the server.

Hardware components and a software structure of the controller 1 (and other controllers that are not shown in FIG. 1A) are similar to those of the controller 0. Details are not described herein again.

FIG. 1A shows a disk-controller separated centralized storage system. In the system, the engine 121 may not have a hard disk slot, the hard disk 134 needs to be placed in a hard disk enclosure 130, and the back-end interface 126 communicates with the hard disk enclosure 130. The back-end interface 126 exists in the engine 121 in a form of adapter card, and one engine 121 may be connected to a plurality of hard disk enclosures through two or more back-end interfaces 126. Alternatively, the adapter card may alternatively be integrated on a mainboard. In this case, the adapter card may communicate with the processor 123 through a PCIE bus.

It should be noted that FIG. 1A shows only one engine 121. However, during actual application, the storage system may include two or more engines 121, and redundancy or load balancing is performed among a plurality of engines 121.

The hard disk enclosure 130 includes a control unit 131 and several hard disks 134. The control unit 131 may have a plurality of forms. Usually, there may be one control unit 131 or two or more control units 131. When the hard disk enclosure 130 includes at least two control units 131, there may be a belonging relationship between the hard disk 134 and the control unit 131. A function of the control unit 131 may be offloaded to a network adapter 104. In other words, in this implementation, the hard disk enclosure 130 does not have the control unit 131 inside, but the network adapter 104 completes data read/write, address translation, and another computing function. In this case, the network adapter 104 is an intelligent network adapter, and the network adapter may include a CPU and a memory. In some application scenarios, the network adapter 104 may further have a persistent memory medium, for example, a persistent memory (Persistent Memory, PM), a non-volatile random access memory (Non-Volatile Random Access Memory, NVRAM), or a phase change memory (phase change memory, PCM). The CPU is configured to perform operations such as address translation and data read/write. The memory is configured to temporarily store data that is to be written into the hard disk 134, or data this is read from the hard disk 134 and that is to be sent to the controller.

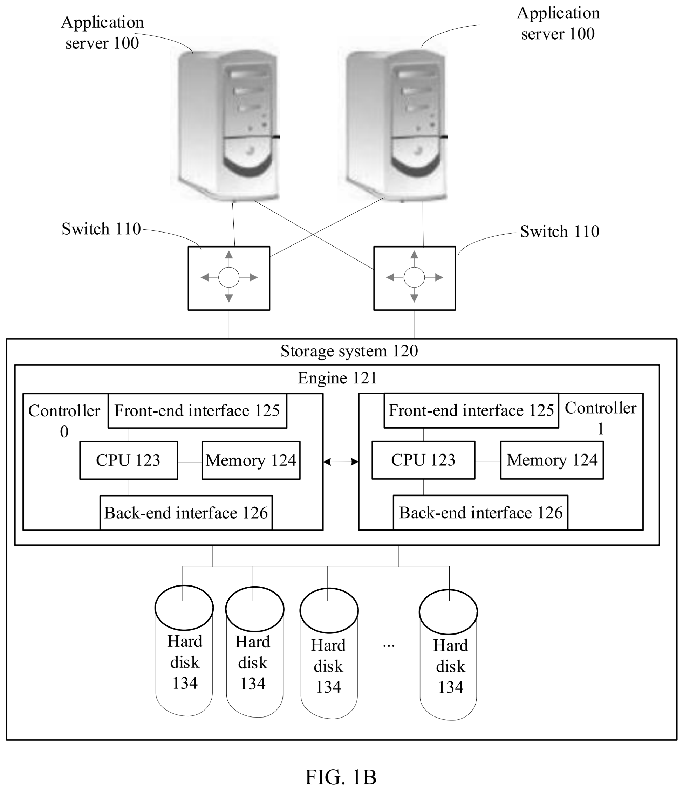

The centralized storage system may alternatively be of a disk-controller integrated architecture. In the disk-controller integrated architecture, the engine 121 has a hard disk slot, and the hard disk 134 may be directly deployed in the engine 121. The back-end interface 126 is an optional configuration. When storage space of the system is insufficient, the engine may be connected to more hard disks or hard disk enclosures through the back-end interface 126. As shown in FIG. 1B, the engine 121 may be connected to more hard disks 134 through the back-end interface 126.

The distributed storage system is a system that disperses and stores data on a plurality of independent storage nodes. The distributed storage system is of a scalable system structure and uses a plurality of storage nodes to share storage load. The distributed storage system improves system reliability, availability, and access efficiency, and is easy to expand.

The distributed storage system may be of a computing-in-memory architecture or a storage-compute decoupled architecture. The following separately provides descriptions.

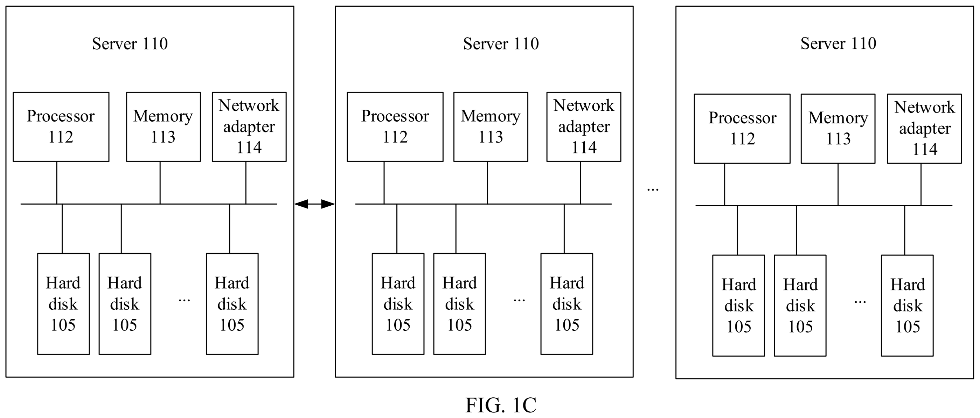

As shown in FIG. 1C, a computing-in-memory distributed storage system includes a storage cluster. The storage cluster includes one or more servers 110 (FIG. 1C shows three servers 110, but is not limited to three servers 110), and the servers 110 may communicate with each other. The server 110 is a device that has both a computing capability and a storage capability, such as a server or a desktop computer. For example, an ARM server or an X86 server may be used as the server 110 herein. In terms of hardware, the server 110 includes at least a processor 112, a memory 113, a network adapter 114, and a hard disk 105. The processor 112, the memory 113, the network adapter 114, and the hard disk 105 are connected through a bus. The processor 112 is a central processing unit (central processing unit, CPU), and is configured to process a data access request from outside of the server 110 (an application server or another server 110), and is also configured to process a request generated inside the server 110. In addition, the processor 112 is further configured to perform computing or processing on data, for example, metadata management, deduplication, data compression, data check, storage space virtualization, and address translation.

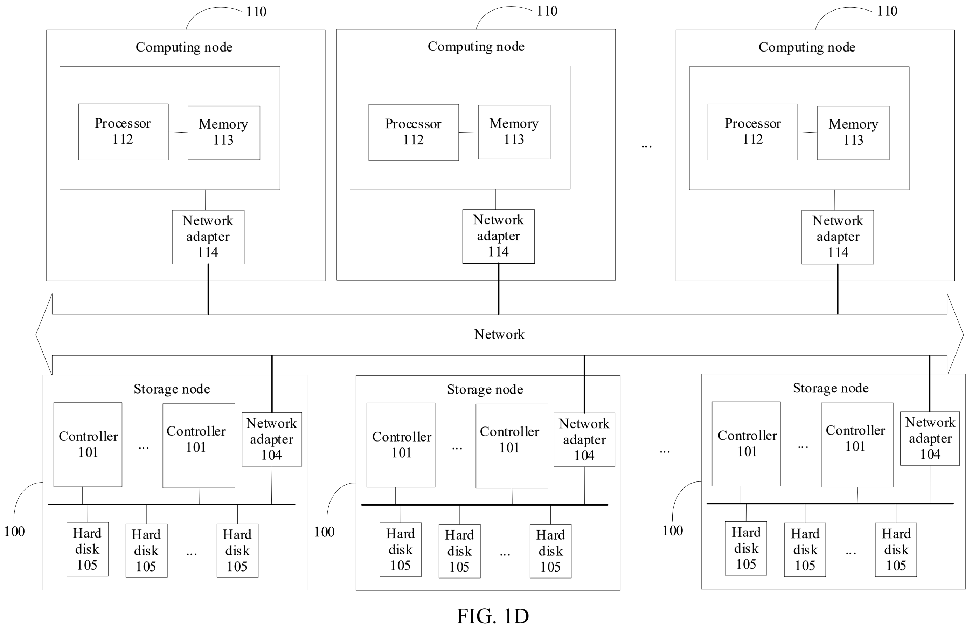

As shown in FIG. 1D, a storage-compute decoupled distributed storage cluster includes a computing cluster (also referred to as a computing node cluster) and a storage cluster (also referred to as a storage node cluster). Computing nodes 110 may communicate with each other. The computing node 110 is a computing device, such as a server, a desktop computer, or a controller of a storage array. In terms of hardware, as shown in FIG. 1D, the computing node 110 includes at least a processor 112, a memory 113, and a network adapter 114. The processor 112 is a central processing unit (central processing unit, CPU), and is configured to process a data access request from outside of the computing node 110 or a request generated inside the computing node 110. When a total amount of data in the memory 113 reaches a specific threshold, the processor 112 sends data stored in the memory 113 to a storage node 100 for persistent storage. In addition, the processor 112 is further configured to perform computing or processing on data, for example, metadata management, deduplication, data compression, storage space virtualization, and address translation.

Any computing node 110 may access any storage node 100 in the storage node cluster through a network. The storage node cluster includes a plurality of storage nodes 100 (FIG. 1D shows three storage nodes 100, but is not limited to three storage nodes 100). One storage node 100 includes one or more controllers 101, a network adapter 104, and a plurality of hard disks 105. The network adapter 104 is configured to communicate with the computing node 110. The hard disk 105 is configured to store data, and may be a magnetic disk or another type of storage medium, for example, a solid-state disk or a shingled magnetic recording hard disk. The controller 101 is configured to write data into the hard disk 105 or read data from the hard disk 105 based on a data read/write request sent by the computing node 110. In a data read/write process, the controller 101 needs to convert an address carried in the data read/write request into an address that can be identified by the hard disk. It can be learned that the controller 101 also has some simple computing functions.

It should be noted that the foregoing is merely an example for describing the storage system. In another possible implementation of embodiments of this application, the storage system may alternatively be a distributed storage system or a centralized storage system of another architecture. For example, the storage system may alternatively be a distributed storage system of a fully converged architecture.

When storing data, the storage system may perform data compression to reduce storage space occupation. Data compression ratios of different data compression algorithms may be different. For example, algorithms such as LZ4, ZSTD, and Snappy may achieve data compression ratios of up to multi-fold. However, a data volume increases exponentially. Conventional compression algorithms represented by LZ4, ZSTD, and Snappy are unable to fully meet requirements for massive data production, storage, and application. The industry further proposes new lossless data compression methods that push beyond the limits of the conventional compression algorithms. Public dictionary (Public Dictionary, PD) compression is a typical example of the new lossless data compression methods. Public dictionary compression is a new data compression solution that breaks through local restrictions, to further increase data reduction ratios by mining richer data features in a broader range.

In the following, an example in which a public dictionary is used in a column-based database is used for description. The column-based database uses a table partitioning mechanism, and a table partition is also referred to as a column family. Data of each table partition (column family) is separately stored in a file. For a column family, every K rows of data form a row group (Row Group) (where each row group includes a fixed quantity of destination rows). In each row group, data in each column is continuously stored in a basic data processing unit, for example, a data block (denoted as a block). Because data types of blocks are the same, efficient data compression may be supported.

To accelerate query, the storage system may create a copy of metadata for each column and store the metadata in a separate file. The metadata mainly includes the following four parts:

① Header: including a version number (which, for example, may be represented by a timestamp), a file length, and some statistics.

(2) Column statistics: including a quantity of rows, a quantity of NULL values, cardinality (cardinality) (a quantity of different values), SUM (indicating a sum), a MAX (indicating "maximum") value, and a MIN (indicating "minimum") value.

③ Dictionary reference relationship: The public dictionary is metadata. A data file that references the public dictionary stores a dictionary number of the public dictionary, to establish a reference relationship with the public dictionary.

④ Block address information: The block address information stores a mapping relationship between a block number and a start address and a length of a data file.

A public dictionary and local data files may be in a one-to-many mapping relationship. That is, one public dictionary may be referenced by a plurality of data files. Therefore, there is a life cycle difference between the public dictionary and the local data file. Due to the life cycle difference, during query, after the public dictionary is loaded to a memory, the public dictionary cannot be released if the plurality of data files that reference the public dictionary are not completely deleted. This operation inevitably causes a long tail problem that the public dictionary occupies the memory for a long time and cannot be released. Consequently, metadata expansion occurs, and the memory occupied by the public dictionary increases sharply. As a result, dictionary data is swapped in and swapped out, and the public dictionary that needs to be used cannot be hit in the memory, which may cause performance deterioration.

In view of this, this application provides a data compression method. In the method, during persistence of a first sub-file in a to-be-persisted data file, a dictionary corresponding to the first sub-file is generated based on the first sub-file. After the first sub-file is compressed by using the dictionary to obtain a first compressed file, the first compressed file and the dictionary are persisted in a same persistent file. For example, the persistent file is pre-partitioned, including a data area and a metadata area. The metadata area reserved in the persistent file is pre-filled with the dictionary corresponding to the first sub-file, and the data area reserved in the persistent file is filled with the first compressed file, so that the first sub-file and the dictionary corresponding to the first sub-file are both persisted.

In this way, a single persistent file independently maintains a dictionary corresponding to a sub-file. The dictionary and the sub-file may implement same life cycle management. That is, a life cycle of data in the sub-file and a life cycle of the dictionary are affinity-bound. This solves a long-tail problem that a public dictionary cannot be released because a local data file references a global public dictionary. In this way, the following problem is avoided: Metadata expansion (metadata overflow) is caused because the public dictionary occupies the memory for a long time and cannot be released; consequently, the public dictionary that needs to be used consequently cannot be hit in a memory, frequent swap-in and swap-out are required, and performance deterioration of a storage system is further caused.

In addition, in this method, an existing persistence engine may be reused to persist a compressed file obtained by compressing a sub-file and a dictionary corresponding to the sub-file, and a dedicated persistence engine does not need to be developed to persist the dictionary. In addition, there is a natural mapping relationship between the compressed file and the dictionary in a persistent file, and functions such as persistence of mapping metadata and mapping update do not need to be additionally added. This reduces impact on an existing storage system architecture, and reduces development difficulty and system complexity.

To make the technical solutions of this application clearer and easier to understand, the following uses the storage system in the foregoing embodiment as an example to describe the data compression method provided in this application.

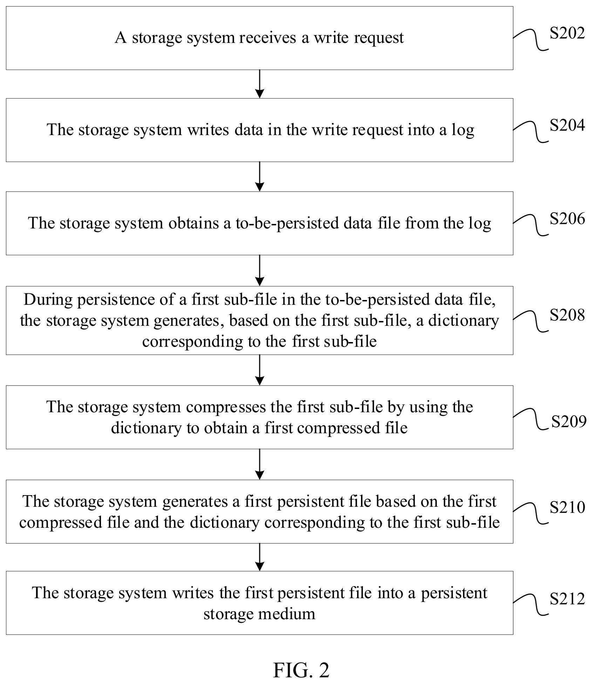

Refer to a flowchart of a data compression method shown in FIG. 2. The method includes:
S202: A storage system receives a write request.

The write request, also referred to as write input/output (input/output, I/O), is a request for writing data. Specifically, a client may generate a write request in response to a write operation triggered by a user, and the storage system receives the write request delivered by the client. The write request includes to-be-written data.

S204: The storage system writes the data in the write request into a log.

Specifically, in a data write phase, the storage system may write the data in the write request into the log in a manner of append-only write (Append-only). For example, the storage system records the data into a write-ahead log (write-ahead log, WAL), which is also referred to as a write-ahead log, and subsequently dumps data in the log to a persistent storage medium, for example, periodically dumps the data to a disk, to ensure high reliability and high availability of the data.

It should be noted that S204 is an optional step in this embodiment of this application, and S204 may not be performed during execution of the method in this application. For example, the storage system may directly flush the data in the write request to the persistent storage medium.

S206: The storage system obtains a to-be-persisted data file from the log.

The to-be-persisted data file is a data file that needs to be flushed to the persistent storage medium. The to-be-persisted data file may include a plurality of sub-files. Column-based database application is used as an example. The to-be-persisted data file may be a database table, and the data table may include a plurality of table partitions (column families). Data in the table partition (column family) may form the sub-file in the to-be-persisted data file.

Specifically, the storage system may update the log to a memory structure, where the memory structure is a data structure in memory, for example, a memory table (denoted as Memtable). When the memory structure, for example, the Memtable, meets a persistence condition, the storage system may trigger persistence. The persistence condition may be that a capacity of the memory structure reaches a target value and/or that duration since a latest data write reaches target duration.

When triggering persistence, the storage system may obtain data updated from the log to the memory structure, and obtain the to-be-persisted data file. In some examples, when the storage system triggers persistence, a current memory table may be set to read-only (or the current memory table may be frozen), to obtain an immutable memory table (immutable Memtable). A data file formed by data in the immutable Memtable may be a sub-file, for example, a first sub-file, in the to-be-persisted data file.

Further, the storage system may create a new memory table to update other data in the log to the new memory table. When the new memory table meets the persistence condition, the new memory table may be set to read-only, and data in the new memory table forms a sub-file, for example, a second sub-file, in the to-be-persisted data file.

It should be noted that S202 to S206 are a specific implementation in which the storage system obtains the to-be-persisted data file. In another possible implementation in this embodiment of this application, the to-be-persisted data file may alternatively be obtained in another manner. For example, the storage system may directly determine the data in the write request as the to-be-persisted data file. A manner of obtaining the to-be-persisted data file is not limited in this application.

S208: During persistence of the first sub-file in the to-be-persisted data file, the storage system generates, based on the first sub-file, a dictionary corresponding to the first sub-file.

In a process of dumping the log to the persistent storage medium (for example, log flushing), the storage system may generate, based on the first sub-file, the dictionary corresponding to the first sub-file. The dictionary may be a public dictionary. Specifically, the first sub-file may include one or more data blocks (data blocks), and the storage system may segment the data block to obtain a training sample and a test sample. The storage system may generate the dictionary based on the training sample, and then perform a test based on the test sample in a test set, for example, compress the test sample by using the dictionary and then collect statistics on a compression ratio. When the compression ratio meets a requirement, for example, the compression ratio is greater than a target compression ratio, the dictionary is determined as a final dictionary. When the compression ratio does not meet the requirement, a new dictionary is generated.

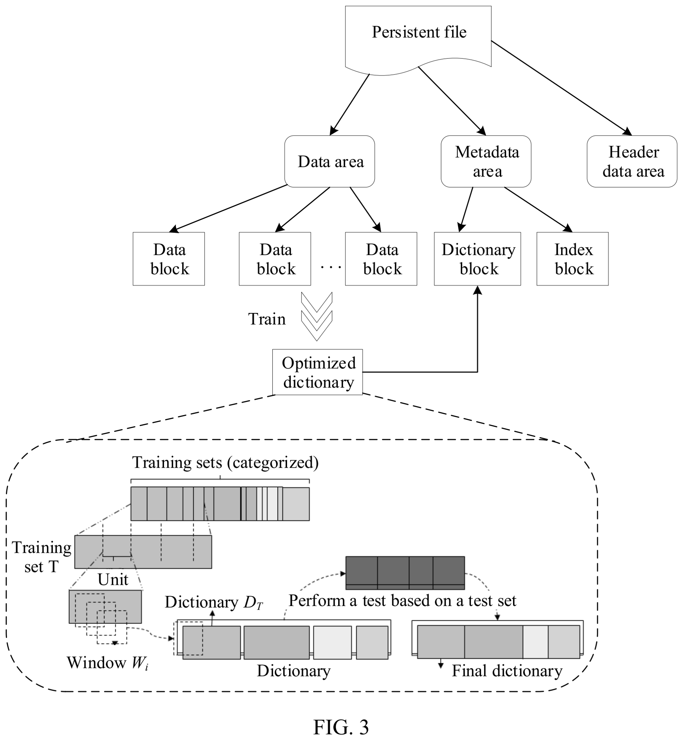

The following describes a dictionary generation process in detail with reference to an example. Refer to a schematic flowchart of dictionary generation shown in FIG. 3. The storage system obtains a data block of the first sub-file, and segments the data block to obtain a training set and a test set. The storage system may segment the data block using a variable-length segmentation mechanism based on frequency of strings corresponding to a window in the data block, to obtain segments of the data block. For example, the storage system may determine highly associated strings based on the frequency of the strings, group the highly associated strings into a same segment, and group weakly associated strings into different segments. In this way, different strings in a same segment are considered as a whole to participate in a subsequent dictionary training process. This improves efficiency of processing the strings, and reduces frequency of interference information being loaded into the dictionary.

Further, a training sample in the training set includes segments of different categories, for example, segments in different languages. The storage system may cluster the segments in the training sample, to obtain training sets (training sets) of different categories. A training set of each category includes a training sample of the category, and a training sample of each category includes a segment of the category. The storage system trains dictionaries of the categories based on the training sets of the categories. Correspondingly, the storage system may compress strings of different data types in the data block by using dictionaries of different categories. In this way, a compression ratio can be further improved, and compression effect can be ensured.

The following uses a dictionary of a category among the dictionaries of the categories as an example for description. A set of segments of a target category may form a training set, for example, a training set T. A dictionary trained based on the training set is denoted as $D_T$. The following describes a training process. The storage system may segment the training set T into a plurality of units. Then, the storage system may set a window based on a window length in dictionary parameters, the window slides on each unit in the training set T, and scores of the window are determined for different locations to which the window slides. For each unit, when a score of the window for a location to which the window slides meets a specified condition, the storage system may load a string corresponding to the window to a dictionary of the target category, to generate the dictionary of the target category.

In some embodiments, sizes of the plurality of units may be fixed. A string corresponding to a window is selected from each unit. Therefore, the storage system may determine a quantity of units based on a size of the compression dictionary $D_T$ and the window length. Further, the storage system may determine a size of each unit based on the quantity of units. Specifically, the storage system may perform segmentation into units according to the following formula:

$$\text{Quantity of units} = \frac{\text{Size of } D_T}{k}$$

$$\text{Size of each unit} = \frac{\text{Size of a training set T}}{\text{Quantity of units}} \tag{1}$$

k represents the window length.

During specific implementation, the storage system may obtain scores of different strings in the window based on frequency of the different strings in the window (for example, when a string is present in different units, a quantity of the units may be determined as frequency of the string). Then, the storage system may obtain, based on the scores of the different strings in the window, a score of the window for a location to which the window slides. Specifically, the storage system may determine a score of the window for each location to which the window slides, according to the following formula:

$$\text{Score of a window } W_i = \sum_{s \epsilon W_i} \text{score of a string s} \tag{2}$$

A window whose score meets a specified condition may be a window whose score is the highest, or a window whose score is greater than a preset score. In this embodiment, the window whose score is the highest is used as an example for description. The storage system may output, to the dictionary $D_T$, a string corresponding to a window whose score is the highest in each unit.

Similarly, the storage system may generate a dictionary of another category based on a training set of the another category. The storage system may merge the dictionaries of the categories.

The storage system may compress the test sample by using the dictionary obtained through training, collect statistics on compression ratios and compression time of the categories, and then optimize the dictionary based on the compression ratio and the compression time. For example, the storage system may perform segment reduction on the dictionary when the compression ratio decreases to an acceptable range (for example, greater than or equal to a minimum compression ratio), to obtain a final dictionary. When performing segment reduction, the storage system may select a segment with a small compression ratio contribution for reduction. For example, the storage system may reduce a segment whose compression ratio contribution is less than a first preset value. For another example, the storage system may perform segment increase on the dictionary to obtain a final dictionary. Specifically, the dictionary may increase a segment whose compression ratio contribution is greater than a second preset value, and specifically, load more strings, to improve an overall compression ratio.

If a fault occurs in the dictionary generation process, because the log still exists, the storage system may perform data replay based on the log, to regenerate the dictionary corresponding to the first sub-file.

It should be noted that, during persistence of the second sub-file in the to-be-persisted data file, the storage system may generate, based on the second sub-file, a dictionary corresponding to the second sub-file. For a specific implementation of generating, by the storage system based on the second sub-file, the dictionary corresponding to the second sub-file, refer to related content descriptions of generating, based on the first sub-file, the dictionary corresponding to the first sub-file. Details are not described herein again.

S209: The storage system compresses the first sub-file by using the dictionary to obtain a first compressed file.

S210: The storage system generates a first persistent file based on the first compressed file and the dictionary corresponding to the first sub-file.

The first persistent file includes the dictionary corresponding to the first sub-file and the first compressed file. Similarly, the storage system may compress the second sub-file based on the dictionary corresponding to the second sub-file to obtain a second compressed file, and then generate a second persistent file based on the second compressed file and the dictionary corresponding to the second sub-file. The second persistent file includes the dictionary corresponding to the second sub-file and the second compressed file.

In some possible implementations, the persistent file may be pre-partitioned. Refer to a diagram of partitioning of a persistent file in FIG. 3. The persistent file includes a data area (data area) and a metadata area (meta area) that are pre-allocated. The data area is used to store a compressed file, and the metadata area is used to store metadata including a dictionary. To facilitate quick and accurate obtaining of the dictionary during subsequent data read, the dictionary may be usually stored in a specified location in the metadata area. The specified location may be determined based on configuration information for pre-allocating the metadata area. The configuration information for pre-allocating the metadata area includes an offset of the metadata area in the persistent file and an offset of the dictionary in the metadata area.

In the example of FIG. 3, the dictionary may be stored in the metadata area in a form of dictionary block (dictionary block). The metadata area may further store metadata other than the dictionary, for example, index (index) metadata. The index metadata may be stored in the metadata area in a form of index block (index block). The first persistent file is used as an example for description. A data area of the first persistent file stores the first compressed file, and a metadata area of the first persistent file stores the dictionary corresponding to the first sub-file. For example, a start address for storing the dictionary may be determined based on a first address of the first persistent file, an offset of the metadata area in the first persistent file, and an offset of the dictionary in the metadata area. The storage system may store the dictionary at a location of the start address (a specified location in the metadata area).

Further, as shown in FIG. 3, the persistent file may further include a header data area (head area). The head area stores footer metadata, including but not limited to a version number, a file length, or statistics.

The storage system may use a separated space reservation strategy, to obtain the data area and the meta area through segmentation (and further, obtain the head area through segmentation) in the persistent file, and complete space reservation in advance when the persistent file is generated. In this way, after the dictionary is generated, the dictionary is pre-filled in corresponding space reserved in the meta area (that is, the dictionary is filled in the reserved meta area).

The storage system may receive configuration information of partitions, where the configuration information of the partitions includes configuration information of the data area and configuration information of the meta area. The configuration information of the data area may include an offset (or an offset address) of the data area in the persistent file, and the configuration information of the meta area may include the offset (or an offset address) of the meta area in the persistent file. Correspondingly, when the persistent file is generated, the persistent file may be partitioned based on the offset. The meta area may be further partitioned. For example, the configuration information of the meta partition may further include the offset of the dictionary in the meta partition. In this way, the meta partition may be further partitioned, so that the dictionary is stored in the specified location in the meta partition. Correspondingly, when reading the dictionary, the storage system may read the dictionary from the specified location in the meta area of the persistent file based on the first address of the persistent file, the offset of the meta area in the persistent file, and the offset of the dictionary in the meta area, to implement efficient dictionary read and improve read performance. Similarly, the storage system may read the compressed file from the data area of the persistent file based on the first address of the persistent file and the offset of the data area in the persistent file, to implement efficient data read and improve read performance.

In some possible implementations, the head area may be further obtained through segmentation in the persistent file. In some examples, the storage system may determine an area between the first address and the offset address of the data area as the head area. In some other examples, the configuration information of the partitions may further include configuration information of the head area, and the configuration information of the head area may include an offset of the head area in the persistent file.

The head area may store the offset of the data area in the persistent file and the offset of the meta area in the persistent file. When a read operation is performed on the persistent file, the data area may be determined based on the offset, of the data area in the persistent file, stored in the head area, to read the compressed file from the data area; or the meta area may be determined based on the offset, of the meta area in the persistent file, stored in the head area, to read the metadata from the meta area. The head area of the persistent file may further store the offset of the dictionary in the meta area. In this way, the dictionary can be precisely read from the specified location in the meta area. Information such as the offset may be configured. Therefore, to prevent modification of a format of the meta area from affecting another partition, a head area may further be set in the meta area. For example, the meta area may be segmented into the head area, a dictionary area, and an index area. The head area of the meta area may store an offset of another partition (for example, the dictionary area) of the meta area in the meta area.

S212: The storage system writes the first persistent file into a persistent storage medium.

The persistent storage medium may be a hard disk, including but not limited to a mechanical hard disk HDD or a solid-state disk SSD. The storage system may write the first persistent file into the persistent storage medium. In other words, the first compressed file obtained by compressing the first sub-file and the dictionary corresponding to the first sub-file are stored in the persistent storage medium in a form of first persistent file, to implement persistence of data and metadata including the dictionary. Similarly, the storage system may further write the second persistent file into the persistent storage medium. In other words, the second compressed file obtained by compressing the second sub-file and the dictionary corresponding to the second sub-file are stored in the persistent storage medium in a form of second persistent file.

Further, when persistence of the first sub-file fails, the storage system may further recover the first sub-file based on the log. For example, the storage system may replay the log, to recover the first sub-file. In this way, the first sub-file may be re-compressed to obtain the first compressed file, and the first compressed file and the dictionary corresponding to the first sub-file are written into the persistent storage medium again, to implement data and metadata persistence.

In some possible implementations, the storage system may further receive a read request, where the read request is used to read the first sub-file. Correspondingly, the storage system may read the dictionary corresponding to the first sub-file from the specified location in the metadata area of the first persistent file based on configuration information for pre-allocating the meta area, read the first compressed file from the data area of the first persistent file based on configuration information for pre-allocating the data area, and then decompress the first compressed file by using the dictionary corresponding to the first sub-file, to obtain the first sub-file. In consideration of read performance, the storage system may further load the dictionary to a cache to improve decompression efficiency. In a decompression process, the storage system may directly find a unique dictionary corresponding to a sub-file in the data file, to implement zero misalignment between data and the dictionary.

Based on the foregoing content description, in the data compression method in this embodiment of this application, during persistence of a sub-file in a to-be-persisted data file, a dictionary corresponding to the sub-file is generated in real time, and a compressed file obtained by compressing the sub-file by using the dictionary and the dictionary corresponding to the sub-file are persisted together. A dedicated persistence engine does not need to be provided to be responsible for dictionary persistence, and functions such as persistence of mapping metadata and mapping update do not need to be added to a metadata persistence engine. This reduces development difficulty and system complexity. In addition, a metadata area is reserved in a persistent file to pre-fill the dictionary, so that metadata non-intrusiveness and zero-overhead maintenance can be implemented.

For a storage system that uses a manner of append-only write, data that has been persisted may be rewritten. In other words, invalid data or junk data may be generated in the persistent file. The invalid data and the junk data are rewritten data, for example, rewritten data in a sub-file corresponding to a compressed file stored in a data area of the persistent file. Valid data is opposite to the invalid data, and the valid data is unrewritten data, for example, unrewritten data in the sub-file corresponding to the compressed file stored in the data area of the persistent file.

As data is written and overwritten, a valid data proportion in the persistent file decreases gradually. The storage system may perform reclamation to release space. Reclamation of the persistent file may be merging persistent files, generating a new persistent file including valid data, and generating a new dictionary that conforms to a feature of the valid data in the new persistent file, to ensure that the data and the dictionary have high affinity in a whole period.

In some possible implementations, the storage system may set a merging condition. The merging condition may be set according to a service requirement. For example, to save storage space, the merging condition may be set to a condition related to the valid data proportion. For another example, to reduce a waste of resources, the merging condition may be set to a condition related to load, so that merging can be performed during an idle period. Based on this, the merging condition may include one or more of the following:

① an interval between current time and last merging time reaches a merging cycle; ② current load is less than a preset value; ③ a valid data proportion of at least one of a plurality of persistent files that have been written into the persistent storage medium is less than a preset proportion, where valid data is unrewritten data; or ④ a merging request reported when a user triggers a merging operation is detected.

During specific implementation, the storage system may detect whether the merging condition is met. For example, the storage system may set a timer when the persistent files are merged last time. When timing of the timer reaches the merging cycle, it is determined that the interval between the current time and the last merging time reaches the merging cycle. In other words, the storage system may determine that the merging condition ① is met.

When the merging condition is met, the storage system may merge the plurality of persistent files that haven been written into the persistent storage medium, to obtain a new persistent file, and the storage system deletes the plurality of persistent files (also referred to as previous persistent files) that are merged, to reclaim space.

In some possible implementations, the storage system may determine, based on attribute information of persistent files that have been written into the persistent storage medium, the plurality of to-be-merged persistent files, and merge the plurality of persistent files to obtain the new persistent file.

In some examples, attribute information of the persistent file may include write time. The storage system may sort, based on write time of the persistent files that have been written into the persistent storage medium, the persistent files that have been written into the persistent storage medium, and determine, based on a sorting result, the plurality of to-be-merged persistent files. For example, the storage system may determine the plurality of to-be-merged persistent files according to a first-in first-out principle. Based on this, the storage system may determine top-ranked persistent files as the plurality of to-be-merged persistent files. When 2n or (2n+1) persistent files have been written into the persistent storage medium, the storage system may determine persistent files ranked top i (1<i<n) as the to-be-merged persistent files.

In some other examples, the attribute information of the persistent file may include a valid data proportion. The storage system may determine, based on valid data proportions of the persistent files that have been written into the persistent storage medium, the plurality of to-be-merged persistent files, where the plurality of to-be-merged persistent files include persistent files whose valid data proportions are less than the preset proportion. The preset proportion may be set based on an empirical value, for example, may be set to 50%.

The following describes a process of merging the persistent files. Specifically, the storage system may decompress the plurality of persistent files that have been written into the persistent storage medium (for example, the plurality of to-be-merged persistent files that are determined above), respectively obtain valid data from sub-files obtained through decompression, and merge the valid data to obtain a merged sub-file. Next, the storage system may generate, based on the merged sub-file, a dictionary corresponding to the merged sub-file, and compress the merged sub-file by using the dictionary corresponding to the merged sub-file, to obtain a compressed merged file. Then, the storage system may generate the new persistent file based on the compressed merged file and the dictionary corresponding to the merged sub-file.

For a process in which the storage system generates the dictionary corresponding to the merged sub-file, compresses the merged sub-file by using the dictionary corresponding to the merged sub-file, and generates the new persistent file based on the compressed merged file and the dictionary corresponding to the merged sub-file, refer to a process in which the storage system persists the first sub-file in the plurality of sub-files. Details are not described herein again. A read failure may be caused if the storage system still reads data based on an original address mapping relationship after the merged plurality of persistent files are deleted. In view of this, the storage system may further update physical addresses in an address mapping relationship of the plurality of persistent files to a physical address of the new persistent file. When receiving a read request, the storage request may index the physical address of the new persistent file based on an updated address mapping relationship and a logic address (logic block address, LBA) in the read request. For example, the address mapping relationship of the plurality of persistent files may be LBA 1→PBA 1 and LBA 2→PBA 2. When the plurality of persistent files are merged into the new persistent file, the address mapping relationship of the plurality of persistent files may be updated to LBA 1→PBA 3 and LBA 2-PBA 3.

The following describes the process of merging the persistent files and a process of reading the persistent files with reference to an example.

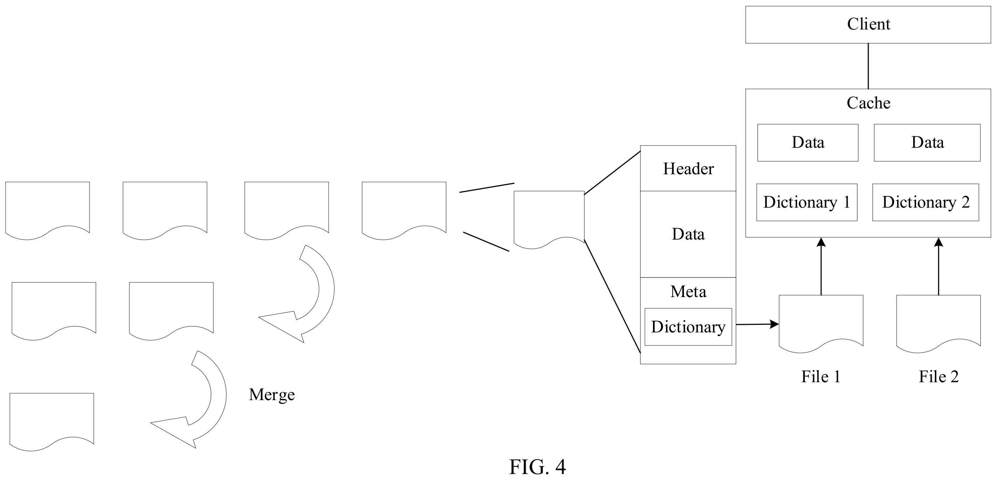

Refer to a schematic flowchart of persistent file merging and reading shown in FIG. 4. In this example, persistent files are stored in a structured merge tree (Log Structured Merge Tree, LSM Tree) manner. When a merging condition is met, a plurality of persistent files in the LSM tree may be merged. For example, valid data proportions of persistent files at an L0 layer are less than 50%. In this case, the persistent files at the L0 layer may be merged to generate a new persistent file and the new persistent file may be written into an L1 layer. When valid data proportions of persistent files at the L1 layer are less than 50%, the persistent files at the L1 layer may be merged to generate a new persistent file and the new persistent file is written into an L2 layer.

The persistent file is segmented into a head area, a data area, and a meta area. Therefore, during merging of the persistent files, the storage system obtains a compressed file from the data area, decompresses the compressed file by using a dictionary in the meta area, respectively extracts valid data from files obtained through decompression, and merges the valid data to obtain a merged sub-file; and further generates, based on the merged sub-file, a new dictionary that conforms to a feature of the merged sub-file, and may generate a new persistent file based on the merged sub-file and the generated new dictionary.

In this example, when reading the persistent file, the storage system may perform precise prefetching on metadata through a metadata cache such as MetaCache. For example, the storage system may precisely prefetch a dictionary 1 (denoted as the dictionary 1, briefly referred to as dict 1) from a persistent file 1 (denoted as a file 1), and precisely prefetch a dictionary 2 (denoted as a dictionary 2, briefly referred to as dict 2) from a persistent file 2 (denoted as a file 2). In this way, a MetaCache hit rate can be improved, and system performance can be maximized.

In this embodiment, during persistence (writing-into-disk) of a sub-file in a data file, the sub-file and a dictionary are persisted at the same time and reclaimed at the same time. As a result, affinity binding between a life cycle of data (for example, the sub-file in the data file) and a life cycle of the dictionary is implemented, zero misalignment between the data and the dictionary is implemented, and no metadata is amplified, to avoid a performance problem caused by metadata overflow.

To make the technical solutions of this application clearer and easier to understand, the following describes the data compression method in this application with reference to a specific application scenario.

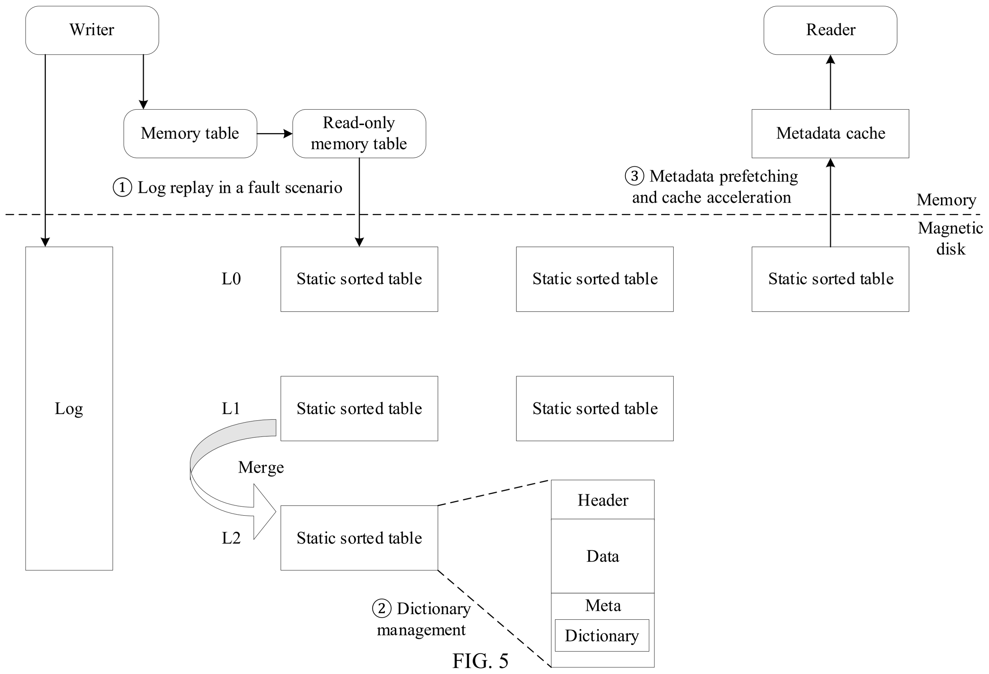

Refer to a diagram of a data compression method in a database shown in FIG. 5. As shown in FIG. 5, a database storage engine includes the following components: a WAL file whose role is similar to that of a transaction log, a memory structure Memtable, and a persistent static sorted table (static sorted table, SST) file. Data is first recorded in a log and then updated to the memory structure Memtable. When a capacity or duration condition is met, a persistence operation (Minor Compaction) is triggered to perform persistence in the SST file. The SST file is segmented into a head area, a data area, and a meta area. The WAL file can be used to: when a fault occurs, restore Memtable that is not written to a magnetic disk.

Specifically, after receiving a write request from an upper layer, a storage system may perform write protection on data in the write request based on a WAL write protection mechanism provided in a structured merge tree (Log Structured Merge Tree, LSM) hierarchical architecture. A write protection process may be as follows: The storage system writes the data into the log, for example, the WAL file, and then writes the data into the memory structure Memtable. Then, the storage system performs serialization and persists serialized data to a disk. As shown in step ① in FIG. 5, when a fault occurs, the storage system may replay the WAL file, to recover the data and perform persistence again.

As shown in step (2) in FIG. 5, when performing persistence, the storage system may preset dictionary filling space (pre-partition) in the meta area of the SST file. In this way, extra metadata management overheads may not be introduced. Based on a current unified metadata service, efficient and highly reliable management of metadata can be implemented, to avoid repeated development workloads caused by re-developing a metadata persistence engine, and avoid complexity caused by management of a plurality of types of metadata.

In addition, for a metadata overflow problem caused by a long tail of a dictionary, in this embodiment, a life cycle of data (for example, a file object such as a first sub-file) and a life cycle of a dictionary (for example, a dictionary corresponding to the first sub-file) are affinity-bound. Specifically, a single SST file independently maintains a dictionary, and dictionary scopes are naturally isolated between SST files. In addition, a database synchronously updates the dictionary in a reclaiming and merging (Major Compaction) process, so that zero misalignment between the data and the dictionary can be ensured, no metadata is amplified, to avoid a problem of performance deterioration caused by metadata overflow.

For a read request from the upper layer, refer to step ③ in FIG. 5. The storage system may perform precise prefetching with reference to fixed index information of each SST file for dictionary space, to improve a cache hit rate for subsequent read request hit, greatly reduce I/O paths, and improve read performance.

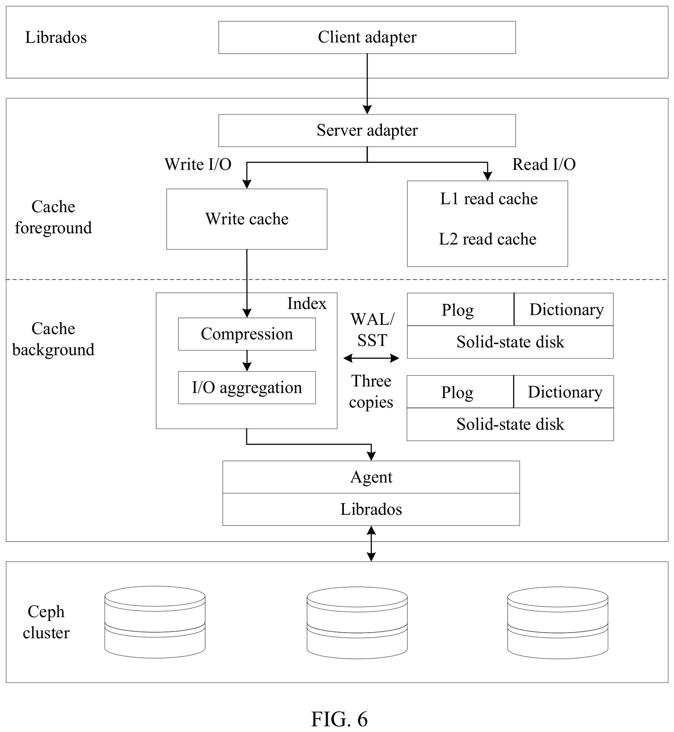

Refer to a diagram of a data compression method in a distributed storage system shown in FIG. 6. The distributed storage system may be a storage-compute decoupled Ceph system, and the Ceph system may be logically divided into a cache layer and a storage layer. The cache layer may be a global cache (global cache, GC), and may specifically include a cache foreground and a cache background. The storage layer may include a Ceph cluster, and the cluster includes a hard disk.

Specifically, a client plug-in such as Librados may be deployed on a client to accelerate read and write of a Ceph system. Librados provides a client adapter (client adapter). The client adapter is configured to perform semantic conversion (also referred to as escape), so that a server can identify read I/O and write I/O. The cache foreground includes a server adapter (server adapter). The server adapter is configured to perform semantic conversion, deliver write I/O to a write cache, and deliver read I/O to a read cache (including an L1 read cache or an L2 read cache). An index system in the cache background performs public dictionary compression on a sub-file in a data file, and a compressed file is written into a persistence log (persistence Log, plog) after I/O aggregation. To resolve a mapping management problem between data and a public dictionary, in this embodiment, the public dictionary is persisted along with the data (for example, a first sub-file in a to-be-persisted data file). Implementation of append-only write into the plog requires the public dictionary to be aggregated at a tail. A native plog design requires a write location of the public dictionary to be negotiated in a distributed manner and a negotiated location to be monotonically increasing. In this embodiment, a plog format may be modified to perform pre-partitioning design on the plog. Specifically, the plog is segmented into a data area, a meta area, and a header area, and the dictionary is pre-filled in the meta area, so that the public dictionary is persisted along with the data.

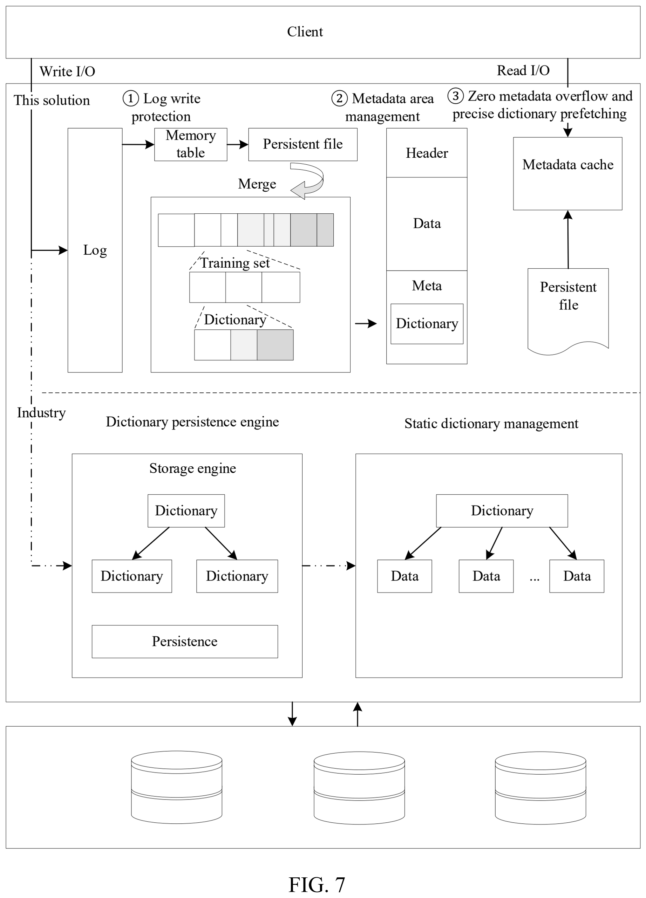

Refer to FIG. 7. In a conventional method, a dedicated dictionary persistence engine needs to be developed to perform dictionary persistence, which leads to a complex storage system architecture and introduces an extra development workload. In addition, a dictionary and data are usually in a one-to-many mapping relationship. When data is queried for the first time, a corresponding metadata file needs to be loaded to a memory and cached, and the dictionary cannot be released provided that table data is not completely deleted. This operation inevitably causes a long-tail problem that the dictionary occupies the memory for a long time and cannot be released. As a result, metadata expansion occurs, and the occupied memory increases sharply. Dictionary data is swapped in and swapped out, and the dictionary cannot be hit in the memory, which causes performance deterioration.

In the data compression method in this application, a separated space reservation strategy is used. Partitions such as a head area, a data area, and a meta area are obtained through segmentation in a persistent file, and space reservation is performed in advance when a file object is generated. Therefore, after the dictionary is generated, the dictionary is pre-filled in corresponding space reserved in the meta area (the dictionary is filled in the reserved meta area). The filling space is fully reserved and configurable.

In addition, for a public dictionary management and persistence problem, in the data compression method in this application, a storage system may first write a log (for example, a WAL), then update the memory, and finally perform serialization and perform persistence to a disk. In this way, in a WAL flushing process, if a fault occurs, data may be replayed and flushed, and the dictionary is regenerated in this process. Because a fault scenario proportion is small (a daily fault rate is 0.1%), a retry upon a fault does not affect performance.

For a problem of metadata expansion and overflow, a single persistent file independently maintains a dictionary. Persistent files and dictionaries may be in a one-to-one correspondence. A life cycle of the data and a life cycle of the dictionary are affinity-bound. When a reclamation or merging operation is performed on the persistent file, the dictionary is updated synchronously. In this way, one-to-one mapping is implemented in the entire life cycle, and the data and the dictionary are persisted at the same time and reclaimed at the same time, to avoid metadata expansion and overflow.

Based on the data compression method in the foregoing embodiments, this application further provides a data compression apparatus. The apparatus may be deployed in the storage systems shown in FIG. 1A to FIG. 1D. The storage system runs the data compression apparatus, to perform the data compression method shown in FIG. 2.

The following describes, with reference to embodiments, a data cache apparatus provided in this application from a perspective of function modularization.

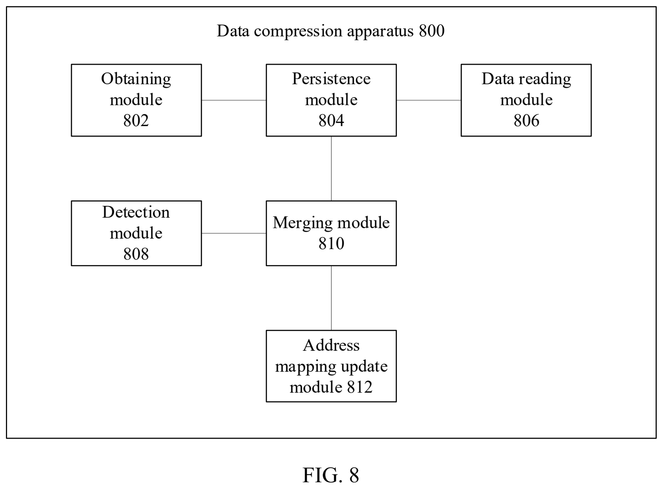

Refer to a diagram of a structure of a data compression apparatus shown in FIG. 8, the data compression apparatus 800 includes:

an obtaining module 802, configured to obtain a to-be-persisted data file, where the to-be-persisted data file includes a plurality of sub-files; and
a persistence module 804, configured to: during persistence of a first sub-file in the plurality of sub-files,
generate, based on the first sub-file, a dictionary corresponding to the first sub-file, and compress the first sub-file by using the dictionary, to obtain a first compressed file;
generate a first persistent file based on the first compressed file and the dictionary; and
write the first persistent file into a persistent storage medium.

The obtaining module 802 and the persistence module 804 may be implemented by software. The obtaining module 802 may be configured to perform method steps S202 to S206 in the embodiment shown in FIG. 2, to obtain the to-be-persisted data file. The persistence module 804 may be configured to perform the method steps of S208 to S212. For specific implementation processes of the obtaining module 802 and the persistence module 804, refer to related content description of the embodiment shown in FIG. 2. Details are not described herein again.

In some possible implementations, the first persistent file includes a data area and a metadata area that are pre-allocated, the data area stores the first compressed file, a specified location in the metadata area stores the dictionary corresponding to the first sub-file, the specified location is determined based on configuration information for pre-allocating the metadata area, and the configuration information for pre-allocating the metadata area includes an offset of the metadata area in the first persistent file and an offset of the dictionary in the metadata area.

Pre-partitioning of the first persistent file may be implemented when the first persistent file is generated. For a partitioning manner of the first persistent file, refer to related content description in S210. Details are not described herein again.

In some possible implementations, the obtaining module 802 is further configured to:
receive a read request, where the read request is used to read the first sub-file.

The apparatus 800 further includes:
a data reading module 806, configured to: read the dictionary corresponding to the first sub-file from the specified location in the metadata area of the first persistent file based on the configuration information for pre-allocating the metadata area, and read the first compressed file from the data area of the first persistent file based on configuration information for pre-allocating the data area, where the configuration information for pre-allocating the data area includes an offset of the data area in the first persistent file; and decompress the first compressed file by using the dictionary corresponding to the first sub-file, to obtain the first sub-file.

For specific implementation of the data reading module 806, refer to related content description of the embodiment shown in FIG. 2. Details are not described herein again.

In some possible implementations, the apparatus 800 further includes:

a detection module 808, configured to detect whether a merging condition is met; and
a merging module 810, configured to: when the merging condition is met, merge a plurality of persistent files that have been written into the persistent storage medium, to obtain a new persistent file; and delete the plurality of persistent files.

For specific implementation of the detection module 808 and the merging module 810, refer to related content description of the embodiment shown in FIG. 4. Details are not described herein again.

In some possible implementations, the merging module 810 is specifically configured to:

decompress the plurality of persistent files that have been written into the persistent storage medium, respectively obtain valid data from sub-files obtained through decompression, and merge the valid data to obtain a merged sub-file, where the valid data is unrewritten data;

generate, based on the merged sub-file, a dictionary corresponding to the merged sub-file, and compress the merged sub-file by using the dictionary corresponding to the merged sub-file, to obtain a compressed merged file; and

generate the new persistent file based on the compressed merged file and the dictionary corresponding to the merged sub-file.

In a possible implementation, the merging condition includes at least one of the following:

an interval between current time and last merging time reaches a merging cycle;

current load is less than a preset value;

a valid data proportion of at least one of the plurality of persistent files that have been written into the persistent storage medium is less than a preset proportion, where the valid data proportion is a proportion of unrewritten data in a sub-file corresponding to the persistent file; or

a merging request reported when a user triggers a merging operation is detected.

In some possible implementations, the merging module 810 is specifically configured to:

determine, based on attribute information of persistent files that have been written into the persistent storage medium, the plurality of to-be-merged persistent files; and

merge the plurality of persistent files to obtain the new persistent file.

In some possible implementations, attribute information of the persistent file includes write time or a valid data proportion, and the valid data proportion is a proportion of unrewritten data in a sub-file corresponding to the persistent file.

The merging module 810 is specifically configured to:

sort, based on write time of the persistent files that have been written into the persistent storage medium, the persistent files that have been written into the persistent storage medium, and determine, based on a sorting result, the plurality of to-be-merged persistent files; or

determine, based on valid data proportions of the persistent files that have been written into the persistent storage medium, the plurality of to-be-merged persistent files, where the plurality of to-be-merged persistent files include persistent files whose valid data proportions are less than the preset proportion.

In some possible implementations, the apparatus 800 further includes:

an address mapping update module 812, configured to update a physical address in an address mapping relationship of the plurality of persistent files to a physical address of the new persistent file.

For specific implementation of the address mapping update module 812, refer to related content description of the embodiment shown in FIG. 4. Details are not described herein again.

An embodiment of this application further provides a computer-readable storage medium. The computer-readable storage medium may be any usable medium that can be stored by a computing device, or a data storage device, such as a data center, including one or more usable media. The usable medium may be a magnetic medium (for example, a floppy disk, a hard disk, or a magnetic tape), an optical medium (for example, a DVD), a semiconductor medium (for example, a solid-state disk), or the like. The computer-readable storage medium includes instructions, and the instructions instruct a storage system to perform the foregoing data compression method.

An embodiment of this application further provides a computer program product including instructions. The computer program product may be software or a program product that includes the instructions and that can be run on a storage system or stored in any usable medium. When the computer program product is run on the storage system, the storage system is enabled to perform the foregoing data compression method.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some technical features thereof, without departing from the protection scope of the technical solutions of embodiments of the present invention.

**Claims**

1. A data compression method, wherein the method comprises:

   obtaining a to-be-persisted data file, wherein the to-be-persisted data file comprises a plurality of sub-files; and
   during persistence of a first sub-file in the plurality of sub-files,
   generating, based on the first sub-file, a dictionary corresponding to the first sub-file, and compressing the first sub-file by using the dictionary, to obtain a first compressed file;
   generating a first persistent file based on the first compressed file and the dictionary; and
   writing the first persistent file into a persistent storage medium.

2. The method according to claim 1, wherein the first persistent file comprises a data area and a metadata area that are pre-allocated, the data area stores the first compressed file, a specified location in the metadata area stores the dictionary corresponding to the first sub-file, the specified location is determined based on configuration information for pre-allocating the metadata area, and the configuration information for pre-allocating the metadata area comprises an offset of the metadata area in the first persistent file and an offset of the dictionary in the metadata area.

3. The method according to claim 2, wherein the method further comprises:

   receiving a read request, wherein the read request is used to read the first sub-file;
   reading the dictionary corresponding to the first sub-file from the specified location in the metadata area of the first persistent file based on the configuration information for pre-allocating the metadata area, and reading the first compressed file from the data area of the first persistent file based on configuration information for pre-allocating the data area, wherein the configuration information for pre-allocating the data area comprises an offset of the data area in the first persistent file; and
   decompressing the first compressed file by using the dictionary corresponding to the first sub-file, to obtain the first sub-file.

4. The method according to any one of claims 1 to 3, wherein the method further comprises:

   detecting whether a merging condition is met; and
   when the merging condition is met, merging a plurality of persistent files that have been written into the persistent storage medium, to obtain a new persistent file; and deleting the plurality of persistent files.

5. The method according to claim 4, wherein merging the plurality of persistent files that have been written into the persistent storage medium, to obtain the new persistent file comprises:

   decompressing the plurality of persistent files that have been written into the persistent storage medium, respectively obtaining valid data from sub-files obtained through decompression, and merging the valid data to obtain a merged sub-file, wherein the valid data is unrewritten data;
   generating, based on the merged sub-file, a dictionary corresponding to the merged sub-file, and compressing the merged sub-file by using the dictionary corresponding to the merged sub-file, to obtain a compressed merged file; and
   generating the new persistent file based on the compressed merged file and the dictionary corresponding to the merged sub-file.

6. The method according to claim 4, wherein the merging condition comprises at least one of the following:

   an interval between current time and last merging time reaches a merging cycle;
   current load is less than a preset value;
   a valid data proportion of at least one of the plurality of persistent files that have been written into the persistent storage medium is less than a preset proportion, wherein the valid data proportion is a proportion of unrewritten data in a sub-file corresponding to the persistent file; or
   a merging request reported when a user triggers a merging operation is detected.

7. The method according to any one of claims 4 to 6, wherein merging the plurality of persistent files that have been written into the persistent storage medium, to obtain the new persistent file comprises:

determining, based on attribute information of persistent files that have been written into the persistent storage medium, the plurality of to-be-merged persistent files; and

merging the plurality of persistent files to obtain the new persistent file.

8. The method according to claim 7, wherein attribute information of the persistent file comprises write time or a valid data proportion, and the valid data proportion is a proportion of unrewritten data in a sub-file corresponding to the persistent file; and

determining, based on the attribute information of the persistent files that have been written into the persistent storage medium, the plurality of to-be-merged persistent files comprises:

sorting, based on write time of the persistent files that have been written into the persistent storage medium, the persistent files that have been written into the persistent storage medium, and determining, based on a sorting result, the plurality of to-be-merged persistent files; or

determining, based on valid data proportions of the persistent files that have been written into the persistent storage medium, the plurality of to-be-merged persistent files, wherein the plurality of to-be-merged persistent files comprise persistent files whose valid data proportions are less than the preset proportion.

9. The method according to any one of claims 4 to 8, wherein the method further comprises:

updating physical addresses in an address mapping relationship of the plurality of persistent files to a physical address of the new persistent file.

10. A data compression apparatus, wherein the apparatus comprises:

an obtaining module, configured to obtain a to-be-persisted data file, wherein the to-be-persisted data file comprises a plurality of sub-files; and

a persistence module, configured to: during persistence of a first sub-file in the plurality of sub-files,

generate, based on the first sub-file, a dictionary corresponding to the first sub-file, and compress the first sub-file by using the dictionary, to obtain a first compressed file;

generate a first persistent file based on the first compressed file and the dictionary; and

write the first persistent file into a persistent storage medium.

11. The apparatus according to claim 10, wherein the first persistent file comprises a data area and a metadata area that are pre-allocated, the data area stores the first compressed file, a specified location in the metadata area stores the dictionary corresponding to the first sub-file, the specified location is determined based on configuration information for pre-allocating the metadata area, and the configuration information for pre-allocating the metadata area comprises an offset of the metadata area in the first persistent file and an offset of the dictionary in the metadata area.

12. The apparatus according to claim 11, wherein the obtaining module is further configured to:

receive a read request, wherein the read request is used to read the first sub-file; and

the apparatus further comprises:

a data reading module, configured to: read the dictionary corresponding to the first sub-file from the specified location in the metadata area of the first persistent file based on the configuration information for pre-allocating the metadata area, and read the first compressed file from the data area of the first persistent file based on configuration information for pre-allocating the data area, wherein the configuration information for pre-allocating the data area comprises an offset of the data area in the first persistent file; and

decompress the first compressed file by using the dictionary corresponding to the first sub-file, to obtain the first sub-file.

13. The apparatus according to any one of claims 10 to 12, wherein the apparatus further comprises:

a detection module, configured to detect whether a merging condition is met; and

a merging module, configured to: when the merging condition is met, merge a plurality of persistent files that have been written into the persistent storage medium, to obtain a new persistent file; and delete the plurality of persistent files.

14. The apparatus according to claim 13, wherein the merging module is specifically configured to:

decompress the plurality of persistent files that have been written into the persistent storage medium, respectively obtain valid data from sub-files obtained through decompression, and merge the valid data to obtain a merged sub-file, wherein the valid data is unrewritten data;

generate, based on the merged sub-file, a dictionary corresponding to the merged sub-file, and compress the merged sub-file by using the dictionary corresponding to the merged sub-file, to obtain a compressed merged file; and

generate the new persistent file based on the compressed merged file and the dictionary corresponding to the merged sub-file.

15. The apparatus according to claim 13, wherein the merging condition comprises at least one of the following:

an interval between current time and last merging time reaches a merging cycle;
current load is less than a preset value;
a valid data proportion of at least one of the plurality of persistent files that have been written into the persistent storage medium is less than a preset proportion, wherein the valid data proportion is a proportion of unrewritten data in a sub-file corresponding to the persistent file; or
a merging request reported when a user triggers a merging operation is detected.

16. The apparatus according to any one of claims 13 to 15, wherein the merging module is specifically configured to:

determine, based on attribute information of persistent files that have been written into the persistent storage medium, the plurality of to-be-merged persistent files; and
merge the plurality of persistent files to obtain the new persistent file.

17. The apparatus according to claim 16, wherein attribute information of the persistent file comprises write time or a valid data proportion, and the valid data proportion is a proportion of unrewritten data in a sub-file corresponding to the persistent file; and
the merging module is specifically configured to:

sort, based on write time of the persistent files that have been written into the persistent storage medium, the persistent files that have been written into the persistent storage medium, and determine, based on a sorting result, the plurality of to-be-merged persistent files; or
determine, based on valid data proportions of the persistent files that have been written into the persistent storage medium, the plurality of to-be-merged persistent files, wherein the plurality of to-be-merged persistent files comprise persistent files whose valid data proportions are less than the preset proportion.

18. The apparatus according to any one of claims 13 to 17, wherein the apparatus further comprises:

an address mapping update module, configured to update physical addresses in an address mapping relationship of the plurality of persistent files to a physical address of the new persistent file.

19. A storage system, wherein the storage system comprises a controller and a hard disk; and the controller executes computer-readable instructions, so that the storage system performs the method according to any one of claims 1 to 9.

20. A computer-readable storage medium, comprising computer-readable instructions, wherein the computer-readable instructions are used for implementing the method according to any one of claims 1 to 9.

FIG. 1A

Application server 100

Application server 100

Switch 110

Switch 110

Storage system 120

Engine 121

Controller 0    Front-end interface 125

Front-end interface 125    Controller 1

CPU 123    Memory 124

CPU 123    Memory 124

Back-end interface 126

Back-end interface 126

Hard disk 134

Hard disk 134

Hard disk 134

...

Hard disk 134

FIG. 1B

FIG. 1C

FIG. 1D

EP 4 685 657 A1

A storage system receives a write request — S202

↓

The storage system writes data in the write request into a log — S204

↓

The storage system obtains a to-be-persisted data file from the log — S206

↓

During persistence of a first sub-file in the to-be-persisted data file, the storage system generates, based on the first sub-file, a dictionary corresponding to the first sub-file — S208

↓

The storage system compresses the first sub-file by using the dictionary to obtain a first compressed file — S209

↓

The storage system generates a first persistent file based on the first compressed file and the dictionary corresponding to the first sub-file — S210

↓

The storage system writes the first persistent file into a persistent storage medium — S212

FIG. 2

FIG. 3

EP 4 685 657 A1

Client

Cache

Data

Data

Dictionary 1

Dictionary 2

Header

Data

Meta

Dictionary

File 1

File 2

Merge

FIG. 4

FIG. 5

| Librados | Client adapter |
|---|---|

Server adapter

Write I/O          Read I/O

**Cache foreground**

Write cache

L1 read cache

L2 read cache

**Cache background**

Index

Compression

I/O aggregation

WAL/ SST

Three copies

| Plog | Dictionary |
|---|---|
| Solid-state disk | |

| Plog | Dictionary |
|---|---|
| Solid-state disk | |

Agent

Librados

**Ceph cluster**

FIG. 6

FIG. 7

Data compression apparatus 800

| Obtaining module 802 | | Persistence module 804 | | Data reading module 806 |
| --- | --- | --- | --- | --- |

| Detection module 808 | | Merging module 810 |
| --- | --- | --- |

Address mapping update module 812

FIG. 8

## INTERNATIONAL SEARCH REPORT

International application No.

**PCT/CN2024/089694**

### A. CLASSIFICATION OF SUBJECT MATTER

G06F16/174(2019.01)i; G06F16/176(2019.01)i

According to International Patent Classification (IPC) or to both national classification and IPC

### B. FIELDS SEARCHED

Minimum documentation searched (classification system followed by classification symbols)

IPC: G06F

Documentation searched other than minimum documentation to the extent that such documents are included in the fields searched

Electronic data base consulted during the international search (name of data base and, where practicable, search terms used)

CNKI, CNTXT, VEN, ENTXT, USTXT, IEEE: 数据, 文件, 压缩, 持久化, 字典, data, file, compression, persistence, dictionary

### C. DOCUMENTS CONSIDERED TO BE RELEVANT

| Category* | Citation of document, with indication, where appropriate, of the relevant passages | Relevant to claim No. |
|---|---|---|
| A | CN 115774699 A (BENYUAN DATA (BEIJING) INFORMATION TECHNOLOGY CO., LTD.) 10 March 2023 (2023-03-10) <br> description, paragraphs [0027]-[0103], and figures 1-10 | 1-20 |
| A | CN 110851409 A (NANJING TRANSWARP INTELLIGENT TECHNOLOGY CO., LTD.) 28 February 2020 (2020-02-28) <br> entire document | 1-20 |
| A | CN 111679860 A (SHANGHAI ICEKREDIT, INC.) 18 September 2020 (2020-09-18) <br> entire document | 1-20 |
| A | US 2019155788 A1 (SAP SE) 23 May 2019 (2019-05-23) <br> entire document | 1-20 |

☐ Further documents are listed in the continuation of Box C.    ☑ See patent family annex.

| * | Special categories of cited documents: | | |
|---|---|---|---|
| "A" | document defining the general state of the art which is not considered to be of particular relevance | "T" | later document published after the international filing date or priority date and not in conflict with the application but cited to understand the principle or theory underlying the invention |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **12 July 2024** | **17 July 2024** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
| PCT/CN2024/089694 |

| Patent document cited in search report | | | Publication date (day/month/year) | Patent family member(s) | Publication date (day/month/year) |
|---|---|---|---|---|---|
| CN | 115774699 | A | 10 March 2023 | None | |
| CN | 110851409 | A | 28 February 2020 | None | |
| CN | 111679860 | A | 18 September 2020 | None | |
| US | 2019155788 | A1 | 23 May 2019 | None | |

Form PCT/ISA/210 (patent family annex) (July 2022)

**EP 4 685 657 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202310473699

- CN 202310803573